# DEMANDE DE BREVET EUROPEEN

(11) **EP 4 478 699 A1**
(43) Date de publication de la demande: **18.12.2024**
(21) Numéro de dépôt: 24180167.9
(22) Date de dépôt: 05.06.2024
(51) Int. Cl.: H04N 5/64, H04N 21/41

(54) **MODULE CAMERA RAPPORTE A MONTAGE VERTICAL**

(30) Priorité: 13.06.2023 FR 2305998
(71) Demandeur: Sagemcom Broadband SAS, 92270 Bois-Colombes (FR)
(72) Inventeur: CHUSSEAU, Hugo, 92270 BOIS-COLOMBES (FR)
(74) Mandataire: Cabinet Boettcher

(57) **Abrégé**

Module électrique (20), destiné à être intégré dans un équipement électrique (1), comportant :
- un support (21), un trou (36) et des bords latéraux agencés pour mettre en œuvre une liaison glissière pour insérer le support verticalement dans une échancrure (8) pratiquée dans un bord d'une face latérale (5a) du boîtier (2) de l'équipement ;
- au moins un composant de protection contre la poussière ;
- une carte électrique comprenant une caméra (51) ;
le module électrique (20) étant tel que la carte électrique est fixée au support de sorte que la caméra est en regard du trou, et le au moins un composant de protection forme, avec une épaisseur du support, une enceinte (71) dans laquelle est positionnée une lentille de la caméra.

## Description

L'invention concerne le domaine des équipements électriques intégrant une caméra.

### ARRIERE PLAN DE L'INVENTION

On connaît des équipements électriques qui comprennent un boîtier et une caméra intégrée dans le boîtier.

Aujourd'hui, par exemple, certains fabricants de boîtiers décodeurs (ou STB, pour *Set-Top Box*) envisagent d'intégrer une caméra dans leurs équipements.

La caméra peut être intégrée directement dans l'une des faces du boîtier de l'équipement, généralement dans la face avant. Cette conception répond à des exigences fonctionnelles mais aussi cosmétiques.

Cette conception présente l'inconvénient suivant pour le fabricant de l'équipement électrique, qui réalise l'assemblage final. Celui-ci doit maîtriser parfaitement la propreté de la ligne d'assemblage de l'équipement électrique, pour éviter les pollutions de la lentille de la caméra par dépôt de poussières.

Les fournisseurs de caméras recommandent une classe ISO 8 pour les postes d'assemblage. Les concentrations maximales admissibles en particules sont les suivantes, dans une salle blanche ISO 8 :
- 3 520 000 particules par mètre cube, de taille supérieure ou égale à 0,5 um ;
- 832 000 particules par mètre cube, de taille supérieure ou égale à 1 um ;
- 29 300 particules par mètre cube, de taille supérieure ou égale à 5 um.

Les postes d'assemblage à environnement contrôlé, permettant d'assurer que ces concentrations ne sont pas dépassées, ont un coût et un encombrement élevés. Or, lorsque l'intégration d'une caméra n'appartient pas au coeur de métier traditionnel d'un fabricant d'équipement électrique, comme c'est le cas pour un fabricant de boîtiers décodeurs, les lignes d'assemblage de ce fabricant ne sont pas équipées de tels postes d'assemblage. Le traitement de ce problème de pollution engendre donc une complexification et une nette augmentation du coût des lignes d'assemblage.

Certains fabricants d'équipements électriques sont par ailleurs confrontés à une autre contrainte.

Généralement, les équipements électriques du marché intégrant une caméra en face avant sont assemblés suivant une direction d'assemblage parallèle à l'axe de la caméra, c'est-à-dire selon une direction avant/arrière.

Cependant, certains équipements électriques sont conçus pour une direction d'assemblage haut/bas, et donc orthogonale à l'axe de la caméra. La ligne d'assemblage doit donc intégrer aussi cette contrainte de pluralité des directions d'assemblage, ce qui la complexifie à nouveau.

### OBJET DE L'INVENTION

L'invention a pour objet de simplifier et de réduire le coût de l'assemblage selon une direction verticale d'un équipement électrique intégrant une caméra, tout en résolvant le problème de pollution par la poussière.

### RESUME DE L'INVENTION

En vue de la réalisation de ce but, on propose un module électrique, destiné à être intégré dans un équipement électrique, et comportant :
- un support qui comprend une paroi interne, un trou traversant le support dans son épaisseur, et des bords latéraux agencés pour mettre en oeuvre une liaison glissière pour insérer le support verticalement dans une échancrure pratiquée dans un bord inférieur ou supérieur d'une face latérale d'une partie de boîtier de l'équipement électrique ;
- au moins un composant de protection contre la poussière ;
- une carte électrique comprenant une caméra ;
le module électrique étant tel que, lorsqu'il est assemblé, la carte électrique est fixée à la paroi interne du support de sorte que la caméra est positionnée en regard du trou, et le au moins un composant de protection contre la poussière forme, avec une épaisseur du support, une enceinte dans laquelle est positionnée une lentille de la caméra et qui la protège de la poussière.

Lorsque le module électrique a été assemblé, de préférence dans un environnement contrôlé, la lentille de la caméra est protégée de la poussière. Le module électrique rapporté peut alors être intégré dans un second temps dans l'équipement électrique de manière classique, sans nécessiter de poste d'assemblage à environnement contrôlé.

Le fabricant de l'équipement électrique peut ainsi faire assembler le module électrique par une autre entité, recevoir le module électrique, puis assembler l'équipement électrique dans une ligne d'assemblage « traditionnelle ». On réduit ainsi nettement le coût et la complexité de l'assemblage pour le fabricant de l'équipement électrique, qui n'a pas besoin de modifier sa ligne d'assemblage à cause de la présence de la caméra.

Le module électrique rapporté peut par ailleurs être intégré verticalement, facilement et rapidement, dans la face latérale de la partie de boîtier de l'équipement électrique grâce à la liaison glissière.

On propose de plus un module électrique tel que précédemment décrit, dans lequel le au moins un composant de protection contre la poussière comprend un joint positionné autour de la lentille de la caméra entre la carte électrique et le support, et une vitre de protection fixée à une paroi externe du support.

On propose de plus un module électrique tel que précédemment décrit, dans lequel le support comprend au moins un premier plot de fixation situé à proximité d'un premier bord latéral du support, et au moins un deuxième plot de fixation situé à proximité d'un deuxième bord latéral du support, le premier plot de fixation et le deuxième plot de fixation permettant de fixer la carte électrique à la paroi interne du support, un axe longitudinal de chaque plot de fixation étant incliné vers le haut, par rapport à un plan horizontal, d'un angle non nul.

On propose de plus un module électrique tel que précédemment décrit, le support comprenant en outre une première patte de fixation et une deuxième patte de fixation qui s'étendent selon le plan horizontal et qui permettent de fixer le module électrique à la partie de boîtier, la première patte de fixation et la deuxième patte de fixation s'étendant latéralement et vers l'extérieur du support respectivement depuis le premier plot de fixation et le deuxième plot de fixation de sorte que, lorsque le module électrique est assemblé, la carte électrique est positionnée entre la première patte de fixation et la deuxième patte de fixation.

On propose de plus un module électrique tel que précédemment décrit, dans lequel le support comporte deux premiers plots de fixation et deux deuxièmes plots de fixation, et dans lequel un premier microphone et un deuxième microphone sont montés sur la carte électrique, le premier microphone et le deuxième microphone étant en communication acoustique avec l'extérieur via respectivement un premier conduit et un deuxième conduit formés sur le support, le premier conduit s'étendant entre les deux premiers plots de fixation et le deuxième conduit entre les deux deuxièmes plots de fixation.

On propose de plus un module électrique tel que précédemment décrit, dans lequel un récepteur infrarouge est monté sur la carte électrique, le support étant fabriqué avec une matière transparente ou translucide à la lumière infrarouge.

On propose de plus un équipement électrique comprenant :
- un module électrique tel que précédemment décrit ;
- un boîtier comportant une partie de boîtier ayant une face latérale comprenant un bord inférieur ou supérieur dans lequel une échancrure est formée, des bords latéraux de l'échancrure étant agencés pour coopérer avec les bords latéraux du support pour mettre en oeuvre la liaison glissière ;
une paroi externe du support du module électrique s'étendant dans l'échancrure pour former une portion d'une paroi externe de la face latérale de la partie de boîtier.

On propose de plus un équipement électrique tel que précédemment décrit, dans lequel la partie de boîtier comprend une nervure de renfort qui s'étend verticalement depuis un fond de la partie de boîtier, en reliant entre eux les bords latéraux de l'échancrure.

On propose de plus un équipement électrique tel que précédemment décrit, l'équipement électrique étant un boîtier décodeur.

L'invention sera mieux comprise à la lumière de la description qui suit d'un mode de mise en oeuvre particulier non limitatif de l'invention.

### BREVE DESCRIPTION DES DESSINS

Il sera fait référence aux dessins annexés parmi lesquels :
[Fig. 1] la figure 1 est une vue en perspective, de dessus et depuis l'avant, du boîtier décodeur qui se trouve dans une position nominale de fonctionnement ;
[Fig. 2] la figure 2 est une vue en perspective, de dessous et depuis l'arrière, du boîtier décodeur sans le châssis inférieur du boîtier ;
[Fig. 3] la figure 3 est une vue similaire à celle de la figure 2, mais depuis l'avant du boîtier décodeur ;
[Fig. 4] la figure 4 est une vue de détail de la figure 2 ; [Fig. 5] la figure 5 est une vue en perspective, depuis l'avant et en éclaté, du module électrique ;
[Fig. 6] la figure 6 est une vue similaire à celle de la figure 5, mais depuis l'arrière du module électrique ; [Fig. 7] la figure 7 est une vue partielle et de côté du support du module électrique ;
[Fig. 8] la figure 8 est une vue similaire à celle de la figure 7, mais depuis l'arrière du support.

### DESCRIPTION DETAILLEE DE L'INVENTION

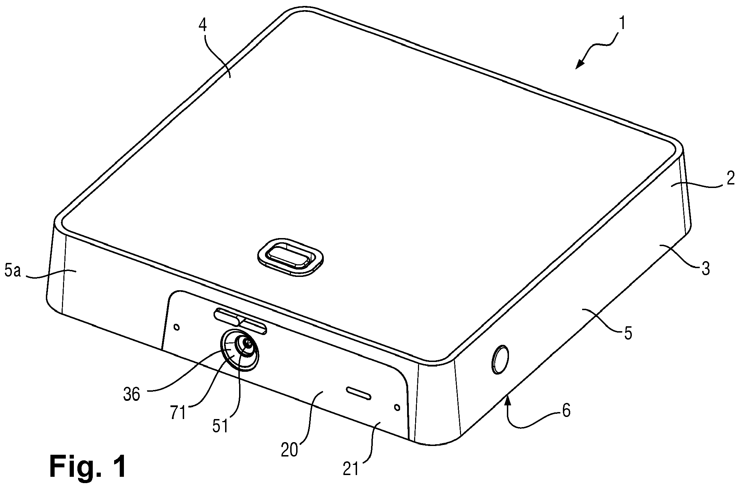

En référence à la figure 1, le boîtier décodeur 1 comporte un boîtier 2.

Le boîtier 2 comprend une partie de boîtier 3, qui comporte une face supérieure 4 et des faces latérales 5. Les faces latérales 5 comprennent une face avant 5a.

La face supérieure 4 et les faces latérales 5 de la partie de boîtier 3 sont aussi celles du boîtier 2.

Le boîtier 2 comporte aussi un châssis inférieur 6, qui forme sa face inférieure.

Un haut-parleur (non représenté), orienté vers le haut, est intégré dans le boîtier décodeur 1. Sa membrane débouche au niveau de la face supérieure 4 de la partie de boîtier 3 (qui est aussi la face supérieure du boîtier 2). Les sons émis par le haut-parleur sortent du boîtier 2 vers le haut par un ou des trous formés dans la face supérieure 4 (non représentés).

Le boîtier décodeur 1, lorsqu'il se trouve dans sa position nominale de fonctionnement, est installé de sorte que la face inférieure 6 du boîtier 2 repose sur un support (par exemple le meuble sur lequel est aussi posé le téléviseur auquel est connecté le boîtier décodeur), et de sorte que la face avant 5a du boîtier 1 se trouve en face de la position de l'utilisateur.

Ici, tous les termes de position, tels que avant, arrière, supérieur, inférieur, gauche, droite, horizontal, vertical, etc., s'interprètent en considérant que le boîtier décodeur 1 se trouve dans sa position nominale de fonctionnement, et est vu de face (comme s'il était vu par l'utilisateur).

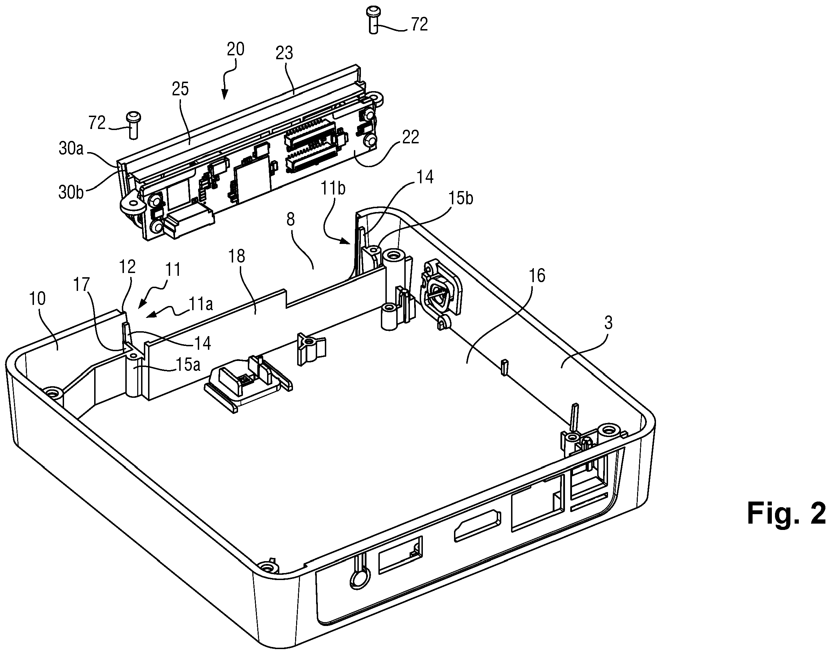

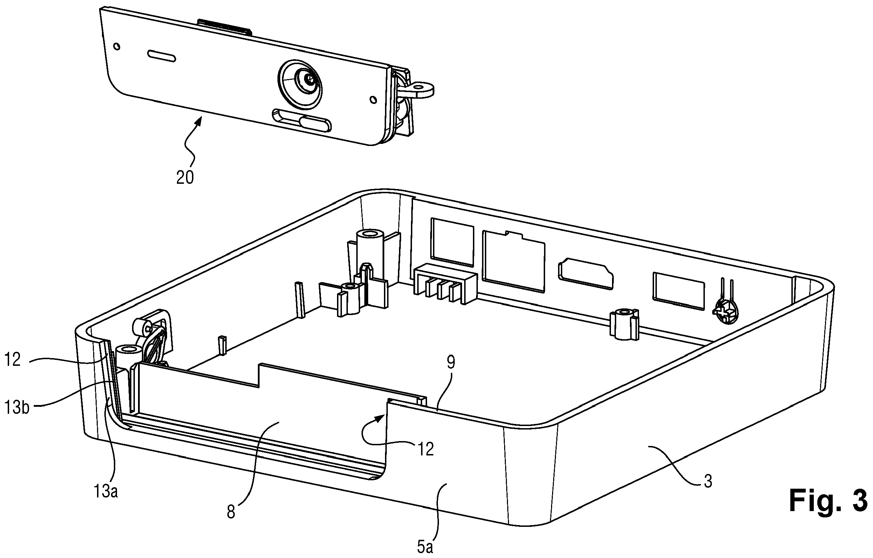

En référence aux figures 2 et 3, une échancrure 8 (découpe) est formée dans le bord inférieur 9 de la face avant 5a de la partie de boîtier 3. L'échancrure 8 est située à droite de la face avant 5a.

L'échancrure 8 a une forme trapézoïdale ayant les coins de son bord supérieur arrondis (coins de la petite base du trapèze). La longueur du bord inférieur de l'échancrure 8 est supérieure à sa hauteur.

La paroi interne 10 (latérale) de la partie de boîtier 3 se prolonge légèrement au niveau des bords latéraux 11a, 11b de l'échancrure 8, définissant ainsi, pour chaque bord latéral 11, une portion 12 qui s'étend sur toute la hauteur dudit bord latéral 11 en longeant ledit bord latéral 11, et qui vient saillir vers le centre de l'échancrure 8. La tranche de chaque bord latéral 11 comprend donc une première surface 13a (côté externe) et une deuxième surface 13b (côté interne) définies dans l'épaisseur de la partie de boîtier 3.

La partie de boîtier 3 comprend aussi deux portions 14 de forme longitudinale, formant des renforts latéraux. Chaque renfort latéral 14 s'étend depuis la paroi interne 10 de la partie de boîtier 3 en longeant un bord latéral 11 au niveau de la surface de la paroi interne 10 appartenant à la portion 12.

La partie de boîtier 3 comprend aussi un premier plot de fixation 15a situé à proximité du premier bord latéral 11a de l'échancrure 8, et un deuxième plot de fixation 15b situé à proximité du deuxième bord latéral 11b de l'échancrure 8.

Les plots de fixation 15 s'étendent verticalement depuis un fond 16 de la partie de boîtier 3. Le fond 16 est la paroi interne de la face supérieure 4. Chaque plot de fixation 15 est relié par une nervure verticale 17 à l'un des renforts latéraux 14.

La partie de boîtier 3 comprend de plus une nervure de renfort 18 qui s'étend verticalement depuis le fond 16 de la partie de boîtier 3 et à l'intérieur de la partie de boîtier 3, en reliant entre eux les bords latéraux 11 de l'échancrure 8. La nervure de renfort 18 est reculée dans la partie de boîtier 3 par rapport à l'échancrure 8.

La nervure de renfort 18 permet de compenser la faiblesse créée dans la partie de boîtier 3 par l'échancrure 8, et donc d'éviter les déformations de la partie de boîtier 3 à la fois pendant sa fabrication lors du procédé d'injection, sous l'effet des contraintes internes à la matière thermoplastique libérées lors du refroidissement de la pièce, et lors du fonctionnement du boîtier décodeur 1 sous l'effet des vibrations générées par le haut-parleur.

Le boîtier décodeur 1 comprend aussi une carte mère, et une antenne positionnée parallèlement et à proximité de la face avant 5a (non représentées).

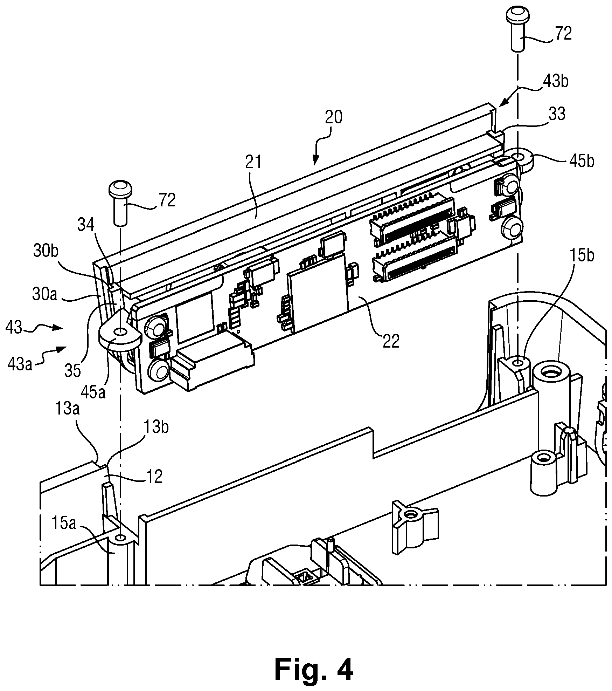

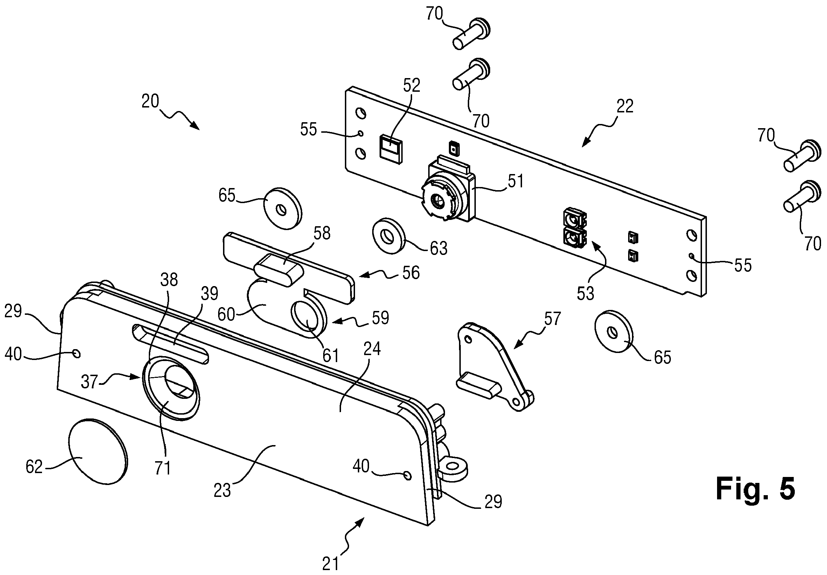

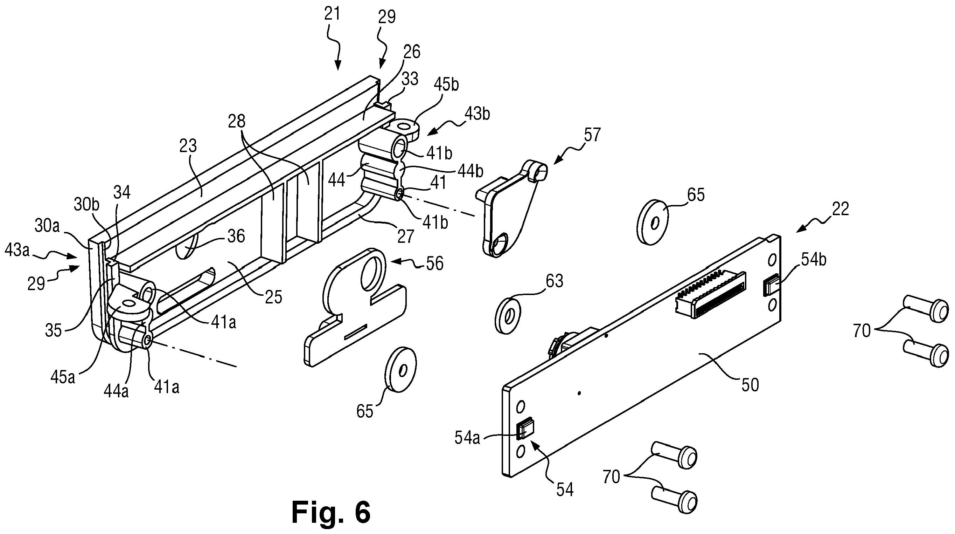

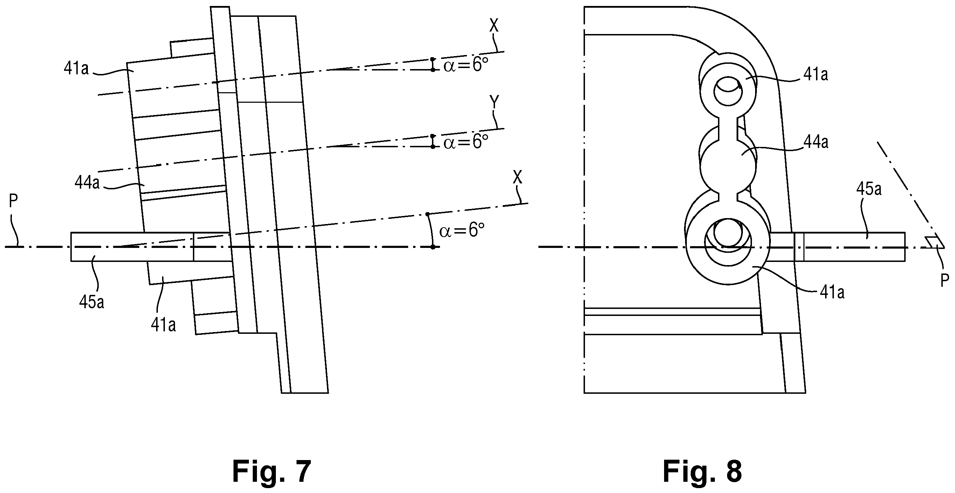

En référence aux figures 4 à 8, le boîtier décodeur 1 comprend de plus un module électrique 20. Le module électrique comporte un support 21 et une carte électrique 22.

Le support 21 comprend une plaque 23 de forme trapézoïdale.

La plaque 23 comprend une paroi externe 24 et une paroi interne 25, qui sont aussi la paroi externe et la paroi interne du support 21.

La paroi externe 24 a la même forme que l'échancrure 8.

Des nervures s'étendent verticalement depuis la paroi interne 25. Les nervures comprennent une nervure 26 qui s'étend parallèlement et à proximité du bord inférieur, une nervure 27 qui longe le bord supérieur et ses coins arrondis, et deux nervures 28 qui relient les nervures 26, 27 en étant perpendiculaires à celles-ci.

L'arête interne de chaque bord latéral 29 de la plaque 23 est évidée de sorte que la tranche de chaque bord latéral 29 présente une première surface 30a (côté externe) et une deuxième surface 30b (côté interne) définies dans l'épaisseur de la plaque 23, la deuxième surface 30b étant renfoncée par rapport à la première surface 30a.

La plaque 23 comporte de plus deux portions 33 en forme de cornière, qui s'étendent depuis sa paroi interne 25. Chaque portion 33 s'étend longitudinalement à proximité d'un bord latéral 29 de la plaque et comprend une aile 34 ayant une surface s'étendant dans la continuité de la deuxième surface 30b, et une aile 35 perpendiculaire à ladite deuxième surface 30b.

La plaque 23 comporte de plus un trou circulaire 36 qui traverse la plaque 23 et donc le support 21 dans son épaisseur. Un épaulement 37 est formé dans l'épaisseur de la plaque 23 autour du trou 36. Cet épaulement 37 définit une surface 38 qui s'étend selon la circonférence du trou 36 et qui est renfoncée par rapport à la paroi externe 24 de la plaque 23.

La plaque 23 comporte de plus un trou 39 oblongue situé au-dessus du trou 36. La longueur du trou 39 est parallèle aux bords supérieur et inférieur de la plaque.

La plaque 23 comporte de plus deux trous 40 circulaires situés chacun à proximité d'un bord latéral 29 distinct de la plaque 23.

Le support 21 comprend au moins un premier plot de fixation 41a situé à proximité d'un premier bord latéral 43a du support, et au moins un deuxième plot de fixation 41b situé à proximité d'un deuxième bord latéral 43b du support.

Ici, le support 21 comprend deux premiers plots de fixation 41a et deux deuxièmes plots de fixation 41b, qui s'étendent chacun depuis la paroi interne 25 de la plaque 23. Les plots de fixations 41 sont ici des plots lisses, les vis utilisées étant auto-taraudeuses (mais les trous pourraient être taraudés).

Les premiers plots de fixation 41a et les deuxièmes plots de fixation 41b permettent de fixer la carte électrique 22 à la paroi interne 25 du support 21.

L'axe longitudinal X de chaque plot de fixation 41 est incliné vers le haut, par rapport à un plan horizontal P, d'un angle α non nul.

L'angle α est ici égal à 6°.

Le support 21 comporte aussi un premier conduit 44a positionné entre les deux premiers plots de fixation 41a, et un deuxième conduit 44b positionné entre les deux deuxièmes plots de fixation 41b. Les axes Y des conduits 44 sont parallèles aux axes longitudinaux X des plots de fixation 41.

Le support 21 comprend en outre une première patte de fixation 45a et une deuxième patte de fixation 45b, qui permettent de fixer le module électrique 20 à la partie de boîtier 3.

La première patte de fixation 45a et la deuxième patte de fixation 45b s'étendent selon un plan horizontal.

La première patte de fixation 45a est positionnée à proximité du premier bord latéral 43a du support, et la deuxième patte de fixation 45b est positionnée à proximité du deuxième bord latéral 43b du support. La première patte de fixation 45a et la deuxième patte de fixation 45b s'étendent latéralement et vers l'extérieur du support 21 respectivement depuis le premiers plot de fixation 41a (plot inférieur) et le deuxième plot de fixation 41b (plot inférieur).

Le support 21 est ici fabriqué dans une matière transparente ou translucide à la lumière infrarouge. Il s'agit par exemple d'une matière plastique de type polycarbonate ou MABS (pour méthacrylate de Méthyle-Acrylonitrile-Butadiène-Styrène) .

La carte électrique 22, quant à elle, comprend un circuit imprimé 50 et des composants montés sur le circuit imprimé.

Ces composant comprennent une caméra 51, un récepteur IR 52 (infrarouge), deux LEDs 53 (pour diodes électroluminescentes), un premier microphone 54a et un deuxième microphone 54b.

La caméra 51, le récepteur IR 52 et la LED 53 sont montés sur la face externe du circuit imprimé 50 (face positionnée vers l'extérieur lorsque le boîtier décodeur 1 est assemblé).

Les deux microphones 54 sont montés sur la face interne du circuit imprimé 50. Le circuit imprimé 50 comprend deux trous 55 permettant chacun d'établir une communication acoustique entre la cellule sensible de l'un des microphones et l'extérieur.

Le module électrique 20 comprend de plus un volet obturateur 56 et des guides de lumière 57. Le volet obturateur 56 comprend une portion préhensible 58 et une portion fonctionnelle 59. La portion préhensible 58 est un pion positionné dans le trou 39 et qui saille sur la paroi externe 24 de la plaque 23 permettant ainsi sa manipulation par un utilisateur. La portion fonctionnelle 59 comprend une surface pleine 60 et un trou 61 ayant les dimensions du trou 36.

Le module électrique 20 comprend de plus au moins un composant de protection contre la poussière, en l'occurrence une vitre de protection 62 circulaire et un joint d'étanchéité 63 annulaire fabriqué ici en mousse.

On décrit maintenant l'assemblage du boîtier décodeur 1.

Le module électrique 20 est tout d'abord assemblé, indépendamment de l'assemblage du reste du boîtier décodeur 1.

Il peut donc s'agir d'un composant indépendant, possédant son propre numéro de composant (P/N) et numéro de série (S/N).

La vitre de protection 62 est tout d'abord positionnée sur la surface 38 de l'épaulement 37 autour du trou 36. La vitre de protection 62 est collée à ladite surface 38.

Le volet obturateur 56 est installé. La portion préhensible 58 du volet est insérée dans le trou 39. En faisant coulisser cette portion préhensible 58 dans le trou 39, l'utilisateur peut sélectivement positionner la surface pleine 60 ou le trou 61 en regard de la lentille de la caméra 51. L'utilisateur peut ainsi permettre à la caméra 51 de produire des images de l'environnement en face du boîtier décodeur 1 ou, au contraire, s'assurer que la caméra 51 ne peut pas produire d'images.

On note qu'optionnellement, la portion préhensible 58 de ce volet 56 est rétroéclairée pour indiquer le statut de la caméra 51 (allumée/éteinte).

Le joint 63 est alors positionné autour de la lentille de la caméra 51.

Pour chaque microphone 54, un joint d'étanchéité 65, ici fabriqué en mousse, est positionné sur la face externe du circuit imprimé 50 en entourant le trou.

Le guide de lumière 57 est positionné en regard des LEDs 53.

La carte électrique 22 est alors positionnée entre la première patte de fixation 45a et la deuxième patte de fixation 45b. La face externe du circuit imprimé 50 de la carte électrique 22 est située en regard de la paroi interne 25 de la plaque 23 du support 21.

La carte électrique 22 est appliquée contre les faces externes des premiers plots de fixation 41a et des deuxièmes plots de fixation 41b, chacune desdites faces externes étant perpendiculaire à l'axe longitudinal X du plot de fixation 41 correspondant.

Le centre de la lentille de la caméra 51 est alors positionné en regard du centre du trou 36.

Les centres des trous 55 des microphones 54 sont de même positionnés en regard des centres des conduits 44. Le premier microphone 54a et le deuxième microphone 54b sont ainsi en communication acoustique avec l'extérieur via respectivement le premier conduit 44a et le deuxième conduit 44b formés sur le support, et via les trous 40 de la plaque 23.

La carte électrique 22 est alors fixée par vissage au support via des vis 70 qui sont vissées dans les plots de fixation 41.

Le joint d'étanchéité 63, positionné entre la carte électrique 22 et le support 21, est donc comprimé. La vitre 62, le joint 63 et l'épaisseur du support 21 (de la plaque 23 en l'occurrence) forment une enceinte 71 dans laquelle est positionnée la lentille de la caméra 51. La lentille est ainsi complètement isolée de l'environnement extérieur par la fenêtre 62 et par le joint 63. L'enceinte 71 permet donc de protéger la lentille de la poussière et de toute pollution.

Les joints d'étanchéité 65 sont eux aussi comprimés. Pour chaque microphone 54, comme on l'a vu, le vissage de la carte 22 est réalisé parallèlement à l'axe du conduit 44 associé à l'aide de deux vis 70 disposées de part et d'autre du joint d'étanchéité 65. On garantit ainsi la compression des joints d'étanchéité 65. On obtient ainsi une atténuation d'au moins 30 dB, et donc de très bonnes performances en reconnaissance vocale.

Lors du vissage, la carte électrique 22 est donc plaquée contre la face externe des plots de fixation 41. L'axe de la caméra 51, qui est lui-même orthogonal au plan de la carte électrique 22, se trouve alors incliné de l'angle α, égal ici à 6°, vers le haut.

L'orientation de l'axe de la caméra 51 vers le haut répond à une spécification fonctionnelle. Cette orientation est permise par l'inclinaison de l'axe longitudinal des plots de fixation 41 vers le haut par rapport à l'horizontal.

Une fois que le module électrique 20 a été assemblé, il est transmis à la ligne d'assemblage en charge de l'assemblage du boîtier décodeur 1.

Le module électrique 20 est alors intégré dans la partie de boîtier 3. Les bords latéraux 43 du support 21 présentent une forme complémentaire des bords latéraux 11 de l'échancrure 8, ce qui permet de mettre en oeuvre une liaison glissière. Lors de l'intégration du module électrique 20, la surface 30a glisse sur la surface 13a, la surface 30b glisse sur la surface 13b, et les renforts 14 glissent dans les cornières 33.

Les bords latéraux 43a, 43b du support 21 du module électrique 20 et les bords latéraux 11a, 11b de l'échancrure 8 présentent donc des nervures de formes complémentaires, qui font office de glissière et permettent d'insérer verticalement le module électrique 20 dans l'échancrure 8 de la partie de boîtier 3.

Les pattes de fixation 45a, 45b viennent s'appuyer sur les plots de fixation 15a, 15b lorsque le module électrique 20 est complètement inséré. Le module électrique 20 est alors fixé par vissage à la partie de boîtier 3 via des vis 72 qui sont vissées dans les plots de fixation 15a, 15b. Les têtes des vis 72 viennent s'appuyer sur les pattes de fixation 45a, 45b du support 21 en fin de vissage.

Le module électrique 20 s'étend ainsi entre la paroi interne 10 de la face avant du boîtier et la nervure de renfort 18.

La paroi externe 24 de la plaque 23 du support 21 du module électrique 20 s'étend dans l'échancrure 8 pour former une portion de la paroi externe de la face latérale du boîtier 1. La paroi externe 24 de la plaque 23 électrique et le reste de la paroi externe de la face avant 5a du boîtier 2 s'étendent dans un même plan, sans discontinuité d'épaisseur.

Le module électrique 20 et son intégration dans le reste du boîtier décodeur 1 présentent un certain nombre d'avantages.

Le module électrique 20 peut être assemblé dans une ligne de production distincte de celle du reste du boîtier décodeur 1. Ceci est particulièrement avantageux. Le fabricant du boîtier décodeur 1, ou tout au moins l'entité en charge de l'assemblage final du boîtier décodeur 1, n'a plus besoin d'avoir un poste d'assemblage ISO 8. En effet, l'assemblage du module électrique 20 peut être réalisé par une autre entité (par exemple par le fournisseur de la caméra ou de la carte électrique) qui transmet alors au fabricant du boîtier décodeur 1 le module électrique 20 tout assemblé. Puis, le fabricant du boîtier décodeur 1 intègre le module électrique rapporté 20 dans le boîtier décodeur 1 sans que cette intégration ne nécessite d'environnement contrôlé ISO 8.

Comme on l'a vu, l'axe de la caméra 51 est orienté vers le haut, par rapport à l'horizontal, d'un angle α (ici égal à 6°). Cette orientation est permise par l'orientation des plots de fixation 41.

Cette orientation de 6° par rapport à l'horizontale des plots de fixation 41 dans le support 21 nécessite une inclinaison suivant le même angle de la direction de démoulage de ces fonctions dans le moule. Il aurait été extrêmement compliqué, si ces fonctions avaient été intégrées directement dans le boîtier 2 sans rapporter le module électrique 20, d'utiliser un outillage dont la direction de démoulage naturelle est verticale. Avec cette solution, la disparité des angles d'assemblage est gérée uniquement sur le support 21 du module électrique 20 en démoulant les pattes de fixation 45 inclinées de 6° par rapport aux autres fonctions, ce qui est beaucoup plus simple à réaliser sur l'outillage du support 21.

On note aussi, en ce qui concerne le module électrique 20, que le vissage à une face latérale du boîtier d'une carte portant les microphones, suivant une direction orthogonale à la carte, serait extrêmement compliqué à réaliser dans le boîtier « complet » pour des problématiques d'accessibilité de la visseuse. Le module électrique 20 permet au contraire un assemblage de la fonction microphones dans le boîtier décodeur 1 par un vissage vertical suivant la direction d'assemblage la plus aisée tout en assurant l'étanchéité au niveau des microphones.

On note de plus que le déport des fonctions de face avant dans le module électrique 20 permet d'optimiser la compacité du boîtier décodeur 1, car toutes les fonctions mécaniques, si elles avaient été conservées dans le boîtier 2, auraient nécessité des cales dans l'outillage pour pouvoir démouler. Il n'aurait pas été possible de conserver une telle proximité entre la carte électrique 22 du module électrique 20 et le haut-parleur, l'antenne de face avant 5a ou la carte mère.

En particulier, comme la face avant du boîtier décodeur 1 est très encombrée, il aurait été impossible d'y inclure une fenêtre transparente ou translucide aux infrarouges de dimensions suffisantes pour ne pas masquer le cône de vision du récepteur IR placé sur la carte 22 sans interférer avec les autres fonctions.

Pour résoudre ce problème, il aurait pu être envisageable de fabriquer la totalité de la partie de boîtier 3 avec un matériau laissant passer les infrarouges, mais cela aurait posé des problèmes de coût, de cosmétique (un tel matériau est plus sensible aux défauts cosmétiques) et d'éco-conception (matière non recyclée).

Au contraire, dans l'invention, seul le support 21 est injecté en matière transparente ou translucide aux infrarouges, ce qui permet de limiter l'emploi de cette matière dans le produit tout en évitant de masquer des portions du cône de réception du récepteur IR et en garantissant ainsi une portée angulaire optimale.

Bien entendu, l'invention n'est pas limitée au mode de réalisation décrit mais englobe toute variante entrant dans le champ de l'invention tel que défini par les revendications.

L'invention peut être mise en oeuvre avec des composants différents de ceux cités ici. Par exemple, les joints d'étanchéité ne sont pas forcément en mousse, les moyens de fixation de la carte au support et du support à la partie de boîtier peuvent être différents (une fixation par clipsage est par exemple envisageable), la carte électrique ne comprend pas forcément de microphone, de LED ou de récepteur IR, etc.

Les formes complémentaires des bords latéraux du support et de l'échancrure peuvent être différentes.

L'échancrure pourrait être réalisée dans le bord supérieur d'une partie de boîtier.

## Revendications

1. Module électrique (20), destiné à être intégré dans un équipement électrique (1), et comportant :
- un support (21) qui comprend une paroi interne (25), un trou (36) traversant le support dans son épaisseur, et des bords latéraux (43a, 43b) agencés pour mettre en oeuvre une liaison glissière pour insérer le support verticalement dans une échancrure (8) pratiquée dans un bord inférieur ou supérieur d'une face latérale (5a) d'une partie de boîtier (3) de l'équipement électrique ;
- au moins un composant de protection (62, 63) contre la poussière ;
- une carte électrique (22) comprenant une caméra (51) ;
le module électrique (20) étant tel que, lorsqu'il est assemblé, la carte électrique (22) est fixée à la paroi interne (25) du support de sorte que la caméra est positionnée en regard du trou, et le au moins un composant de protection contre la poussière forme, avec une épaisseur du support, une enceinte (71) dans laquelle est positionnée une lentille de la caméra et qui la protège de la poussière.

2. Module électrique selon la revendication 1, dans lequel le au moins un composant de protection contre la poussière comprend un joint (63) positionné autour de la lentille de la caméra entre la carte électrique et le support, et une vitre de protection (62) fixée à une paroi externe (24) du support.

3. Module électrique selon l'une des revendications précédentes, dans lequel le support comprend au moins un premier plot de fixation (41a) situé à proximité d'un premier bord latéral (43a) du support, et au moins un deuxième plot de fixation (41b) situé à proximité d'un deuxième bord latéral (43b) du support, le premier plot de fixation et le deuxième plot de fixation permettant de fixer la carte électrique (22) à la paroi interne du support, un axe longitudinal (X) de chaque plot de fixation étant incliné vers le haut, par rapport à un plan horizontal, d'un angle (α) non nul.

4. Module électrique selon la revendication 3, le support comprenant en outre une première patte de fixation (45a) et une deuxième patte de fixation (45b) qui s'étendent selon le plan horizontal et qui permettent de fixer le module électrique à la partie de boîtier (3), la première patte de fixation et la deuxième patte de fixation s'étendant latéralement et vers l'extérieur du support respectivement depuis le premier plot de fixation et le deuxième plot de fixation de sorte que, lorsque le module électrique est assemblé, la carte électrique est positionnée entre la première patte de fixation et la deuxième patte de fixation.

5. Module électrique selon l'une des revendications 3 ou 4, dans lequel le support comporte deux premiers plots de fixation (41a) et deux deuxièmes plots de fixation (41b), et dans lequel un premier microphone (54a) et un deuxième microphone (54b) sont montés sur la carte électrique, le premier microphone (54a) et le deuxième microphone (54b) étant en communication acoustique avec l'extérieur via respectivement un premier conduit (44a) et un deuxième conduit (44b) formés sur le support, le premier conduit s'étendant entre les deux premiers plots de fixation et le deuxième conduit entre les deux deuxièmes plots de fixation.

6. Module électrique selon l'une des revendications précédentes, dans lequel un récepteur infrarouge (52) est monté sur la carte électrique, le support étant fabriqué avec une matière transparente ou translucide à la lumière infrarouge.

7. Equipement électrique comprenant :
- un module électrique (20) selon l'une des revendications précédentes ;
- un boîtier (2) comportant une partie de boîtier (3) ayant une face latérale (5a) comprenant un bord inférieur (9) ou supérieur dans lequel une échancrure (8) est formée, des bords latéraux (11) de l'échancrure étant agencés pour coopérer avec les bords latéraux (43) du support (21) pour mettre en oeuvre la liaison glissière ;
une paroi externe (24) du support (21) du module électrique s'étendant dans l'échancrure pour former une portion d'une paroi externe de la face latérale (5a) de la partie de boîtier.

8. Equipement électrique selon la revendication 7, dans lequel la partie de boîtier (3) comprend une nervure de renfort (18) qui s'étend verticalement depuis un fond (16) de la partie de boîtier, en reliant entre eux les bords latéraux (11) de l'échancrure.

9. Equipement électrique selon l'une des revendications 7 ou 8, l'équipement électrique étant un boîtier décodeur.
